(19) **Europäisches Patentamt**

**European Patent Office**

**Office européen des brevets**

(11) **EP 0 842 738 B1**

(12) **EUROPEAN PATENT SPECIFICATION**

(45) Date of publication and mention
of the grant of the patent:
**10.10.2001 Bulletin 2001/41**

(51) Int Cl.7: **B24B 37/04**, H01L 21/304,
B08B 1/04, B08B 3/04

(21) Application number: **97120107.4**

(22) Date of filing: **17.11.1997**

(54) **Method of and apparatus for polishing and cleaning planar workpiece**

Verfahren und Vorrichtung zum Polieren und Reinigen von flachen Werkstücken

Procédé et dispositif pour polir et nettoyer des pièces planes

(84) Designated Contracting States:
**DE FR**

(30) Priority: **15.11.1996 JP 32114196**

(43) Date of publication of application:
**20.05.1998 Bulletin 1998/21**

(73) Proprietor: **EBARA CORPORATION**
**Ohta-ku, Tokyo (JP)**

(72) Inventors:
• **Shimizu, Noboru**
**Yokohama-shi, Kanagawa-ken (JP)**

• **Kimura, Norio**
**Fujisawa-shi, Kanagawa-ken (JP)**

(74) Representative: **Wagner, Karl H., Dipl.-Ing. et al**
**WAGNER & GEYER**
**Patentanwälte**
**Gewürzmühlstrasse 5**
**80538 München (DE)**

(56) References cited:
**EP-A- 0 807 492**     **WO-A-96/36459**
**DE-C- 197 634**     **JP-A- 7 135 192**
**US-A- 3 906 678**

**Description**

BACKGROUND OF THE INVENTION

Field of the Invention:

The present invention relates to a method of and an apparatus for polishing and cleaning a planar workpiece, and more particularly to a method of and an apparatus for polishing and cleaning a planar workpiece such as a semiconductor wafer, a glass substrate, a liquid crystal panel, or the like which is required to be highly cleaned.

Description of the Prior Art:

As semiconductor devices become more highly integrated in recent years, circuit interconnections become finer and the distances between those interconnections also become smaller. Photolithographic processes for producing interconnections that are 0.5 $\mu$m wide or smaller, particularly, require a flat image-focusing plane for the stepper because the depth between focal points is small. If a dust particle whose size is greater than the distances between the interconnections is present on a semiconductor substrate, then an undesirable short circuit tends to occur between interconnections through the dust particle. Therefore, it is important to keep clean semiconductor wafers while polishing them to a planar surface finish. The same considerations should be applied to processes of polishing other planar workpieces including glass substrates for use as masks and liquid crystal panels.

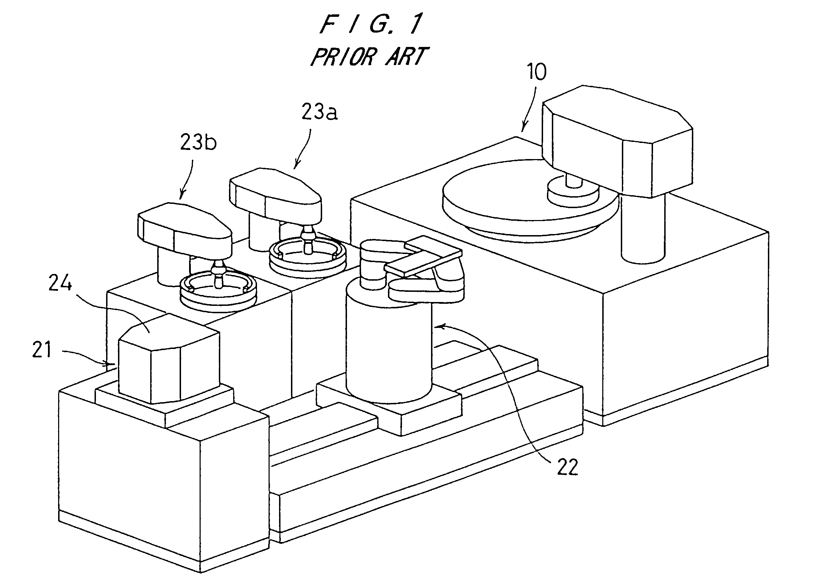

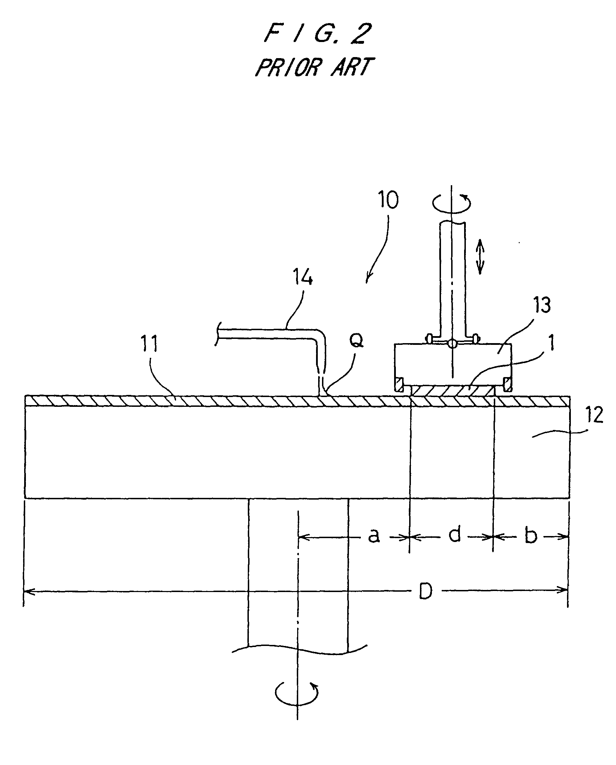

One conventional polishing apparatus is shown in FIG. 1 of the accompanying drawings. As shown in FIG. 1, the conventional polishing apparatus includes a polishing unit 10, a loading/unloading unit 21, a feed robot 22, and two cleaning machines 23a, 23b. As shown in FIG. 2 of the accompanying drawings, the polishing unit 10 comprises a turntable 12 with an abrasive cloth 11 attached to an upper surface thereof, and a top ring 13 for holding and pressing a semiconductor wafer 1 against the abrasive cloth 11 on the turntable 12.

In operation, the semiconductor wafer 1 is supported on the lower surface of the top ring 13, and pressed against the abrasive cloth 11 on the turntable 12 which is being rotated, by a lifting/lowering cylinder. An abrasive solution Q is supplied from an abrasive solution nozzle 14 onto the abrasive cloth 11 and retained by the abrasive cloth 11. The lower surface of the semiconductor wafer 1 is polished by the abrasive cloth 11 while the abrasive solution Q is being present between the semiconductor wafer 1 and the abrasive cloth 11.

The turntable 12 and the top ring 13 rotate at respective speeds that are independent of each other. The top ring 13 holds the semiconductor wafer 1 with its edges being spaced distances "a", "b" from the center and circumferential edge of the turntable 12, by which the entire lower surface of the semiconductor wafer 1 is uniformly polished at a high polishing speed. The semiconductor wafer 1 has a diameter "d". The turntable 12 has a diameter "D" which is selected to be at least twice the diameter "d" of the semiconductor wafer 1, as indicated by the following equation:

$$D = 2(d + a + b)$$

After having been polished, the semiconductor wafer 1 is cleaned and dried in one or more cycles by the cleaning machines 23a, 23b, and then housed in a delivery cassette 24 of the loading/unloading unit 21. When the semiconductor wafer 1 is cleaned, it may be scrubbed by a brush of nylon, mohair, or the like, or a sponge of PVA (polyvinyl alcohol) (see for example JP-A-07 135 192).

Since the turntable 12 and the top ring 13 are displaced to each other in a large extent, and the relative sliding speed between them are relatively large, the semiconductor wafer 1 can be polished efficiently to a flat finish. However, the polished surface of the semiconductor wafer 1 tends to have large surface roughness.

The above mentioned scrubbing process, which is carried out after the semiconductor wafer 1 has been polished using the abrasive solution Q, fails to remove submicron particles from the polished surface of the semiconductor wafer 1, and is not effective enough to clean the polished semiconductor wafer 1 if remaining particles are bonded to the semiconductor wafer 1 by large bonding strength.

SUMMARY OF THE INVENTION

It is therefore an object of the present invention to provide a method of and an apparatus for polishing and cleaning a planar workpiece to a smooth flat surface finish with improved surface roughness, while effectively removing minute particles from the polished surface through a cleaning process.

According to the present invention, there is provided a method of and an apparatus for polishing and cleaning a planar workpiece, comprising, polishing a surface of the planar workpiece by pressing said surface against a first abrasive member which is rotating about its own axis, under a predetermined pressure; and scrubbing said surface with a second abrasive member of a non-woven cloth, a cloth other than a non-woven cloth, or a wiping cloth of ultrafine fibers, which is held against said surface, while scrubbing said surface with said second abrasive member, said surface being pressed against said second abrasive member under a predetermined pressure while said second abrasive member is making circulatory translational motion along a predetermined path.

There is also provided a method of and an apparatus for polishing and cleaning a planar workpiece, comprising, polishing a surface of the planar workpiece by pressing said surface against a first abrasive member which is rotating about its own axis, under a predetermined pressure; and scrubbing said surface with a second abrasive member of a non-woven cloth, a cloth other than a non-woven cloth, or a wiping cloth of ultrafine fibers, which is held against said surface, while scrubbing said surface with said second abrasive member, said surface being pressed against said second abrasive member under a predetermined pressure while said second abrasive member is rotating about its own axis.

According to the present invention, a first abrasive member rotatable about its own axis is pressed to polish a surface of a planar workpiece to a flat finish or to remove a given film thickness from the planar workpiece. Thereafter, a second abrasive member of a nonwoven cloth, a cloth other than a non-woven cloth, or a wiping cloth of ultrafine fibers is held against the surface of the planar workpiece to scrub the planar workpiece. While the surface of the planar workpiece is being scrubbed by the second abrasive member which removes particles from the planar workpiece, the surface of the planar workpiece is polished to a smooth finish by the second abrasive member thereby to improve the surface roughness of the planar workpiece.

In the case when the second abrasive member makes circulatory translational motion during the scrubbing process of the second abrasive member, a cleaning unit which has the second abrasive member takes up an installation space to be the size of which is substantially the same as the sum of the size of the planar workpiece and a space in which the second abrasive member makes circulatory translational motion. The cleaning unit may thus be relatively small in size.

Generally, a polishing apparatus of the circulatory translational motion type may have an abrasive member which is of relatively small dimensions. Then, the relative speed between the surface being polished of a planar workpiece and an abrasive cloth is so small that no sufficient polishing speed cannot be achieved for polishing the planar workpiece. According to the present invention, the second abrasive member which makes circulatory translational motion can be used because no large polishing speed is required by the cleaning unit.

The circulatory translational motion is defined as "a relative motion between a first surface and a second surface facing the first surface and a non-rotational motion which causes every point on the first surface to describe a substantially identical locus with respect to the second surface." The locus may be a circle, an ellipse, a polygon, or any other regular shape. For a better polishing ability and mechanical reasons, the circulatory translational motion should preferably be made along a circular path. The circulatory translational motion along the circular path allows the confronting surfaces to move relatively to each other uniformly in different areas thereof.

The above and other objects, features, and advantages of the present invention will become apparent from the following description when taken in conjunction with the accompanying drawings which illustrate a preferred embodiment of the present invention by way of example.

BRIEF DESCRIPTION OF THE DRAWINGS

FIG. 1 is a perspective view of a conventional polishing apparatus;
FIG. 2 is a vertical cross-sectional view of a polishing unit of the conventional polishing apparatus;
FIG. 3 is a plan view of a polishing and cleaning apparatus according to the present invention;
FIG. 4 is a vertical cross-sectional view of a cleaning unit of the polishing and cleaning apparatus shown in FIG. 3;
FIG. 5 is an enlarged plan view of a support structure on a casing for supporting the edge of a reference plate of the cleaning unit shown in FIG. 4; and
FIG. 6 is a fragmentary cross-sectional view taken along line VI - VI of FIG. 5.

DETAILED DESCRIPTION OF THE PREFERRED EMBODIMENT

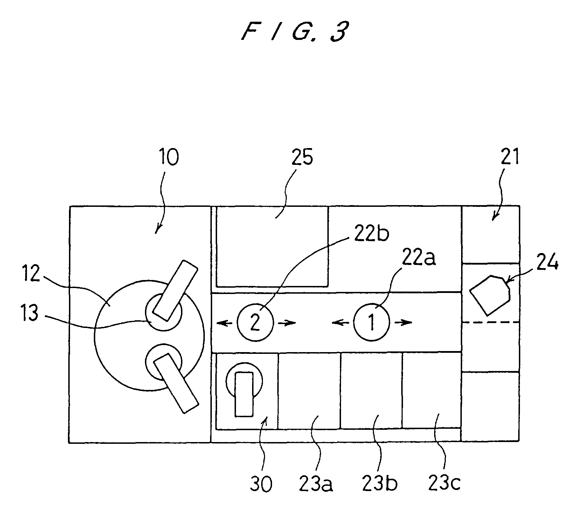

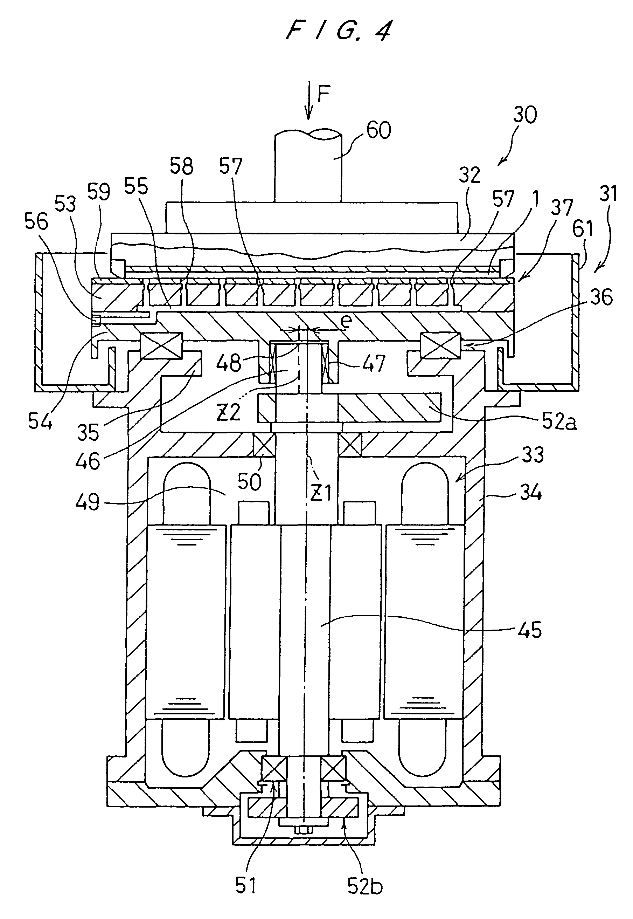

As shown in FIG. 3, a polishing and cleaning apparatus according to the present invention has a loading/ unloading unit 21 positioned at an end of an elongate rectangular space for loading and unloading planar workpieces 1 (see FIG. 4) such as semiconductor wafers or the like, and a main polishing unit 10 positioned at an opposite end of the elongate rectangular space for polishing the planar workpieces 1. The loading/unloading unit 21 and the main polishing unit 10 are interconnected by a workpiece delivery line along which two feed robots 22a, 22b are movable between the loading/unloading unit 21 and the main polishing unit 10. The polishing and cleaning apparatus also includes a reversing machine 25 disposed on one side of the workpiece delivery line for reversing the workpieces 1, a cleaning unit 30 and three conventional cleaning units 23a, 23b, 23c disposed on the other side of the workpiece delivery line, the cleaning units 23a, 23b, 23c comprising rinsing machines or scrubbing machines using brushes, sponges, or the like.

The main polishing unit 10 comprises a turntable 12 and two top rings 13 for polishing two workpieces at the same time. Except for the two top rings 13, the main polishing unit 10 is basically the same as the polishing unit 10 shown in FIGS. 1 and 2.

The cleaning unit 30 will be described below with reference to FIGS. 4 through 6.

The cleaning unit 30 comprises a translational table 31 which provides a polishing tool surface that makes circulatory translational motion, and a top ring 32 for holding a planar workpiece 1 with its lower surface facing downwardly and pressing the planar workpiece 1 against the polishing tool surface.

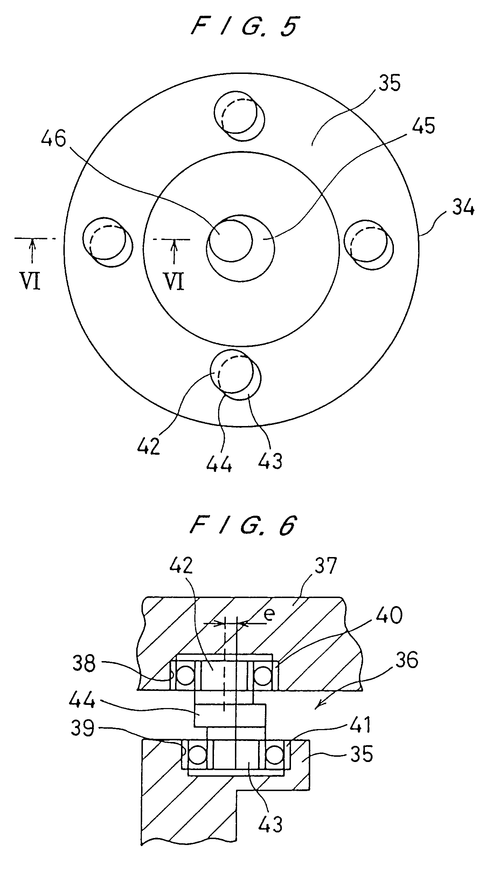

The translational table 31 comprises a vertical cylindrical casing 34 housing an electric motor 33 therein and having an annular support flange 35 extending radially inwardly from an upper edge of the casing 34. The support flange 35 has on its upper surface three or more circumferentially spaced support structures 36 which carry a reference plate 37 thereon. Specifically, as shown in FIG. 6, the reference plate 37 has a plurality of circumferentially equally spaced cavities 38 defined in its lower surface, and the support flange 35 has a plurality of circumferentially equally spaced cavities 39 defined in its upper surface. The cavities 38 and the cavities 39 are slightly horizontally displaced from each other for reasons described below. The support structures 36 comprise respective upper bearings 40 disposed in the respective cavities 38 and respective lower bearings 41 disposed in the respective cavities 39. The upper and lower bearings 40, 41 of each of the support structures 36 are axially interconnected by a cranked joint 44 having upper and lower shafts 42, 43 that are fitted respectively in the upper and lower bearings 40, 41. The shafts 42, 43 and hence the upper and lower bearings 40, 41 have respective axes horizontally spaced from each other by a distance "e". The reference plate 37 is coupled to the motor 33 as described below. When the motor 33 is energized, the reference plate 37 that is coupled to the motor 33 and supported by the support structures 36 can make translational motion along circles each having a radius which is the same as the distance "e".

The reference plate 37 has a tubular member projecting downwardly from the lower surface thereof and defining a recess 48 therein. The motor 33 has a vertical shaft 45 having an upper end connected to an eccentric drive shaft 46 that is rotatably mounted in the recess 48 by a bearing 47. The eccentric drive shaft 46 has its central axis spaced horizontally from a central axis Z1 of the shaft 45. The motor 33 is disposed in a motor chamber 49 that is defined in the casing 34, and the shaft 45 is rotatably supported in the casing 34 by upper and lower bearings 50, 51. Balancers 52a, 52b are attached respectively to upper and lower ends of the shaft 45 for keeping the shaft 45 in a balanced state while the shaft 45 is rotating in unison with the eccentric drive shaft 46.

The reference plate 37 has a diameter which is slightly greater than the sum of the diameter of the planar workpiece 1 to be polished and the distance "e". The reference plate 37 comprises two plate members 53, 54 joined to each other with a space 55 defined therebetween for passing therethrough a cleaning solution to be supplied to a polishing surface. The space 55 is held in communication with a cleaning solution supply port 56 defined in a side edge of the reference plate 37 and also with a plurality of cleaning solution discharge ports 57 defined in the upper plate member 53 and opening upwardly. An abrasive cloth 59 is attached to the upper surface of the reference plate 37 and has a plurality of discharge holes 58 defined therein and aligned in registry with the respective cleaning solution discharge ports 57. Usually, the cleaning solution discharge ports 57 and the discharge holes 58 are scattered substantially uniformly over the entire surface of the reference plate 37. The abrasive cloth 59 may have a gridlike, spiral, or radial pattern of grooves defined in the upper surface thereof, and the discharge holes 58 may be held in communication with those grooves.

The top ring 32 is mounted on the lower surface of a shaft 60 so as to be tiltable to some extent in order to accommodate inclinations of the polishing surface of the abrasive cloth 59. Downward pressing forces applied by an air cylinder (not shown) and rotative forces from a drive motor (not shown) are transmitted through the shaft 60 to the top ring 32. The top ring 32 is structurally identical to the top ring 13 shown in FIGS. 1 and 2 except that the top ring 32 rotates about its axis at a lower speed. The upper end of the casing 34, the reference plate 37, and the top ring 32 are horizontally surrounded by a retrieval reservoir 61 mounted on the upper end of the casing 34 for collecting a cleaning solution that is supplied.

Operation of the polishing and cleaning apparatus will be described below. A planar workpiece 1, typically a semiconductor wafer, in a delivery cassette, similar to the delivery cassette 24 shown in FIG. 1, is delivered by the feed robots 22a, 22b through the reversing machine 25, if necessary, to one of the top rings 13 of the main polishing unit 10, and installed on the top ring 13. The top ring 13 rotates about its own axis and presses the planar workpiece 1 against the abrasive cloth 11 (see FIG. 2) on the turntable 12. The planar workpiece 1 is polished by the abrasive solution Q supplied from the abrasive solution nozzle 14 while the planar workpiece 1 and the abrasive cloth 11 are moving relatively to each other at a high speed.

After having been polished by the main polishing unit 10, the planar workpiece 1 is directly or roughly cleaned, and then transferred to the cleaning unit 30 where the planar workpiece 1 is cleaned. Specifically, the motor 33 is energized to cause the reference plate 37 to make circulatory translational motion, and the planar workpiece 1 attached to the top ring 32 is pressed against the upper surface of the abrasive cloth 59 that is attached to the reference plate 37.

The planar workpiece 1 is then cleaned and polished by a cleaning solution that is supplied to the surface to be polished of the planar workpiece 1 through the cleaning solution supply port 56, the space 55, the cleaning solution discharge ports 57, and the discharge holes 58. The cleaning solution discharge ports 57 and the discharge holes 58 allow the cleaning solution to be supplied at a sufficient rate to the entire area of the planar workpiece 1 including the central area. Since small relative translational motion along circles having the radius "e" occurs between the abrasive cloth 59 and the planar workpiece 1, the planar workpiece 1 is uniformly polished over its entire surface. If the polished surface of the planar workpiece 1 and the abrasive cloth 59 stayed in the same relative positional relationship, then the polished surface of the planar workpiece 1 would be adversely affected by local irregularities of the abrasive cloth 59. To avoid this drawback, the top ring 32 is gradually rotated about its own axis so that the surface of the planar workpiece 1 will not be polished by only local areas of the abrasive cloth 59. Therefore, the surface of the planar workpiece 1 will be polished by successively different areas of the abrasive cloth 59, and hence will more uniformly be polished.

In the polishing process carried out by the main polishing unit 10, since the planar workpiece 1 needs to be polished to a desired planar surface finish or to be polished in a desired polishing speed, the planar workpiece 1 and the polishing cloth 11 are moved relatively to each other at a high speed and pressed against each other under relatively large forces for thereby polishing the planar workpiece 1 to a flat finish, or for thereby polishing the planar workpiece 1 in a high polishing speed. In the cleaning process carried out by the cleaning unit 30, since minute particles need to be removed from the polished surface of the planar workpiece 1 while the planarity and surface roughness of the planar workpiece 1 are also required to be improved, the surface roughness of the abrasive cloth 59 is reduced and the speed at which the planar workpiece 1 and the abrasive cloth 59 are moved relatively to each other and the forces under which the planar workpiece 1 is pressed against the abrasive cloth 59 are smaller than with the polishing process. The cleaning solution is usually pure water, but may be a chemical or a special slurry if necessary. For example, a chemical or a special slurry depending on the nature of the planar workpiece 1 may be supplied between the planar workpiece 1 and the abrasive cloth 59. In the polishing process, the abrasive solution contains abrasive particles. In the cleaning solution, the cleaning solution usually does not contain abrasive particles, but may contain fine abrasive particles.

After the planar workpiece 1 has been cleaned by the cleaning unit 30, the planar workpiece 1 is further cleaned by the cleaning machines 23a ~ 23c and then dried, and thereafter accommodated in the delivery cassette 24.

In the polishing and cleaning apparatus, the main polishing unit 10 has two top rings 13. Therefore, if the time required by the cleaning process is reduced to about half the time required by the polishing process, then the main polishing unit 10 and the cleaning unit 30 can be operated efficiently without a loss time.

Consequently, there is a possibility that the overall throughput of the polishing and cleaning apparatus is much higher than the conventional polishing apparatus shown in FIGS. 1 and 2.

Since the cleaning unit 30 is of the circulatory translational motion type, the diameter of the reference plate 37 may be slightly greater than the diameter of the planar workpiece 1 by only the distance "e". Therefore, the motor 33 may be of a relatively small size, and may take up a relatively small space. These advantages manifest themselves when the planar workpiece 1 such as a semiconductor wafer is larger in size.

Inasmuch as the abrasive cloth 59 does not rotate about its own axis, the relative speed between the planar workpiece 1 and the abrasive cloth 59 remains the same at any position on the planar workpiece 1. Therefore, the planar workpiece 1 can be polished to a planar finish even when polished at a low speed, and can advantageously be polished to a smooth surface finish. An installation space for the cleaning unit 30 may be comparatively small. Because the reference plate 37 of the cleaning unit 30 makes circulatory translational motion, the reference plate 37 can be supported at a plurality of positions along its circumferential edge, as shown in FIG. 4. Therefore, even when the reference plate 37 is subjected to large pressing forces, the reference plate 37 can stably be supported, permitting the planar workpiece 1 to be polished to a higher planar finish than with a turntable which rotates at a high speed.

Examples of average conditions for the polishing and cleaning processes are given as follows:

   1. Polishing process:

      Abrasive solution: Differs depending on the nature of the planar workpiece
      Abrasive cloth: Differs depending on the nature of the planar workpiece
      Surface pressure: 200 ~ 500 g/cm$^2$
      Relative speed: 0.07 ~ 0.6 m/sec.
      Time: Differs depending on the amount to be polished off

   2. Cleaning process:

      Cleaning solution: Water, a chemical, a slurry
      Abrasive cloth: Soft cloth (non-woven cloth, nap-like material)
      Surface pressure: 0 ~ 200 g/cm$^2$
      Relative speed: 0.07 ~ 0.6 m/sec.
      Time: 10 ~ 120 sec.

While the abrasive cloth 59 makes circulatory translational motion in the illustrated embodiment, the planar workpiece 1 may make circulatory translational motion with respect to the abrasive cloth 59. In the illustrated embodiment, the reference plate 37 is caused to make circulatory translational motion by the eccentric drive shaft 46 on the shaft 45 of the motor 33. However, the reference plate 37 may be moved by the sum of motion in an X direction and motion in a Y direction of an X-Y stage, or the abrasive cloth 59 and the planar workpiece 1 may jointly be moved to make circulatory translational motion. In the illustrated embodiment, the reference plate 37 is supported using the cranked joints 44 combined with the bearings 40, 41. However, the reference plate 37 may be supported by a suitable support structure, such as magnetic bearings or lubrication-free slide bearings, which allow the reference plate 37 to make circulatory translational motion while preventing it from rotating about its own axis.

Various changes and modifications may be made in the present invention insofar as they have a polishing unit including a first abrasive member rotatable about its own axis for polishing a planar workpiece while the planar workpiece is being pressed against the first abrasive member under a predetermined pressure, and a cleaning unit including a second abrasive member made of a wiping cloth, a non-woven cloth, or a cloth other than a non-woven cloth for scrubbing and polishing the planar workpiece while being pressed against the polished surface of the planar workpiece. For example, the polishing unit 10 with the two top rings 13 as shown in FIG. 3 may be replaced with the polishing unit 10 with the single top ring 13 as shown in FIG. 2, and the cleaning unit 30 with the reference plate 37 making circulatory translational motion may be replaced with a cleaning unit with the single top ring 13 as shown in FIG. 2. In such a modification, the abrasive solution is used in the polishing unit, whereas the cleaning solution such as water, a chemical, or a slurry, or the like is used in the cleaning unit, and the relative speed between the planar workpiece and the abrasive member, the pressure under which the planar workpiece and the abrasive member are pressed against each other, and the surface roughness of the abrasive member are set to different values in the polishing and cleaning units.

The second abrasive member in the cleaning unit may comprise an abrasive cloth, a wiping cloth, or the like. The abrasive cloth is generally used to polish semiconductor wafers to a flat, mirror-like finish, and available on the market. For example, the abrasive cloth may be a non-woven cloth of polyester, Suba800 or IC-1000 manufactured by Rodel, Inc., Surfin xxx-5, Surfin 000 manufactured by Fujimi Incorporated. The abrasive cloths Suba800, Surfin xxx-5, and Surfin 000 are made of fibers put together by a urethane resin, and the abrasive cloth IC-1000 is made of foamed polyurethane. The foamed polyurethane is porous and has a number of minute dents on its surface which are considered to be capable of holding particles.

The abrasive cloth is basically used to polish semiconductor wafers and is of such a structure as to attract abrasive particles contained in an abrasive solution to its own surface. When the abrasive cloth is used in cleaning semiconductor wafers, the abrasive cloth is effective to easily remove particles that strongly stick to the semiconductor wafers.

Because the cleaning unit uses an abrasive cloth that is originally intended to polish a semiconductor wafer, the abrasive cloth can reduce the surface roughness of the semiconductor wafer and hence makes the surface of the semiconductor wafer flat and smooth when the cleaning unit cleans the semiconductor wafer. This effect of the abrasive cloth was confirmed by way of experimentation.

The wiping cloth is made of ultrafine fibers having a diameter ranging from 1 to 2 μm, and is commercially available as Miracle series (tradename) of Toray, Minimax (tradename) of Kanebo, etc. Since these wiping cloths have 100 ~ 200 thousand fibers per one square inch, they have many points of contact with a workpiece to be wiped, for thereby removing minute particles from the workpiece.

Since the wiping cloth is a thin cloth, it may be attached to the reference plate through a damper of sponge, rubber, or the like so as not to damage the workpiece 1 while cleaning the workpiece 1.

The principles of the present invention are applicable to the cleaning and polishing of various planar workpieces including a glass substrate, a liquid crystal panel, etc. which need to be highly cleaned.

The polishing and cleaning apparatus shown in FIG. 3 may further be modified such that the cleaning units 23a, 23b, 23c, such as rinsing machines or scrubbing machines, may be positioned directly following the polishing unit 10 for removing relatively large particles from the planar workpiece, and the cleaning unit 30 may be positioned following the cleaning units 23a, 23b, 23c for removing submicron particles that cannot be removed by a scrubbing action using a brush, a sponge, or the like, from the workpiece.

Although a certain preferred embodiment of the present invention has been shown and described in detail, it should be understood that various changes and modifications may be made therein without departing from the scope of the appended claims.

**Claims**

1. A method of polishing and cleaning a planar workpiece, comprising the steps of:

polishing a surface of the planar workpiece by pressing said surface against a first abrasive member which is rotating about its own axis, under a predetermined pressure; and scrubbing said surface with a second abrasive member of a non-woven cloth, a cloth other than a non-woven cloth, or a wiping cloth of ultrafine fibers, which is held against said surface, while scrubbing said surface with said second abrasive member, said surface being pressed against said second abrasive member under a predetermined pressure while said second abrasive member is making circulatory translational motion along a predetermined path.

2. A method of polishing and cleaning a planar workpiece, comprising the steps of:

polishing a surface of the planar workpiece by pressing said surface against a first abrasive member which is rotating about its own axis, under a predetermined pressure; and scrubbing said surface with a second abrasive member of a non-woven cloth, a cloth other than a non-woven cloth, or a wiping cloth of ultrafine fibers, which is held against said surface, while scrubbing said surface with said second abrasive member, said surface being pressed against said second abrasive member under a predetermined pressure while said second abrasive member is rotating about its own axis.

3. A method according to claim 1, wherein at least one of said planar workpiece and said second abrasive member is rotated about its own axis at a period greater than the period of said circulatory translational motion while said surface is being scrubbed with said second abrasive member.

4. A method according to claim 1, wherein a cleaning solution comprising at least one of pure water, chemicals, and slurry is applied to said surface while said surface is being scrubbed with said second abrasive member.

5. An apparatus for polishing and cleaning a planar workpiece, comprising:

a polishing unit having a first abrasive member rotatable about its own axis along a polishing surface thereof and pressing means for pressing a surface of the planar workpiece against said polishing surface at an eccentric position thereon under a predetermined pressure; and a cleaning unit having a second abrasive member of a non-woven cloth, a cloth other than a non-woven cloth, or a wiping cloth of ultrafine fibers, which can be held against said surface of the planar workpiece, for scrubbing said surface, said second abrasive member being capable of making circulatory translational motion along a predetermined path, said cleaning unit further including pressing means for pressing said surface against said second abrasive member under a predetermined pressure.

6. An apparatus for polishing and cleaning a planar workpiece, comprising:

a polishing unit having a first abrasive member rotatable about its own axis along a polishing surface thereof and pressing means for pressing a surface of the planar workpiece against said polishing surface at an eccentric position thereon under a predetermined pressure; and a cleaning unit having a second abrasive member of a non-woven cloth, a cloth other than a non-woven cloth, or a wiping cloth of ultrafine fibers, which can be held against said surface of the planar workpiece, for scrubbing said surface, said second abrasive member being rotatable about its own axis, said cleaning unit further including pressing means for pressing said surface against the polishing surface of said second abrasive member at an eccentric position thereon under a predetermined pressure.

**Patentansprüche**

1. Verfahren zum Polieren und Reinigen eines planaren oder ebenen Werkstücks, wobei die folgenden Schritte vorgesehen sind:

Polieren einer Oberfläche des planaren Werkstücks durch Pressen der erwähnten Oberfläche unter einem vorbestimmten Druck gegen ein erstes abreibendes Glied (abrasives Glied), welches sich um seine eigene Achse dreht; Schrubben der Oberfläche mit einem zweiten abreibenden Glied aus einem nicht- gewebten Tuch, einem sich von einem nichtgewebten Tuch unterscheidenden Tuch oder einem Wischtuch aus ultrafeinen Fasern, welches gegen die erwähnte Oberfläche gehalten wird, während die erwähnte Oberfläche mit dem zweiten abreibenden Glied geschrubbt wird, wobei die erwähnte Oberfläche gegen das zweite abreibende Glied unter einem vorbestimmten Druck gepreßt wird, während das zweite abreibende Glied eine kreisförmige Translationsbewegung entlang eines vorbestimmten Pfades ausführt.

2. Verfahren zum Polieren und Reinigen eines planaren Werkstücks, wobei die folgenden Schritte vorgesehen sind:

Polieren einer Oberfläche des planaren Werkstücks durch Pressen der erwähnten Oberfläche unter einem vorbestimmten Druck gegen ein erstes abreibendes Glied, welches sich um seine eigene Achse dreht; Schrubben der erwähnten Oberfläche mit einem zweiten abreibenden Glied aus einem nichtgewebten Tuch, einem sich von einem nichtgewebten Tuch unterscheidenden Tuch oder einem Wischtuch aus ultrafeinen Fasern, welches gegen die Oberfläche gehalten wird, während die Oberfläche mit dem erwähnten zweiten abreibenden Glied geschrubbt wird, wobei die Oberfläche gegen das zweite abreibende Glied unter einem vorbestimmten Druck gedrückt wird, während das abreibende Glied sich um seine eigene Achse dreht.

3. Verfahren nach Anspruch 1, wobei das ebene Werkstück und/oder das zweite abreibende Glied um ihre eigene Achse gedreht werden, mit einer Periode, die größer ist als die Periode der kreisförmigen Translationsbewegung, während die erwähnte Oberfläche mit dem zweiten abreibenden Glied geschrubbt wird.

4. Verfahren nach Anspruch 1, wobei eine Reinigungslösung auf die erwähnte Oberfläche aufgebracht wird, während die erwähnte Oberfläche mit dem zweiten abreibenden Glied geschrubbt wird, wobei die Reinigungslösung reines Wasser und/oder Chemikalien und/oder Aufschlämmung umfaßt.

5. Vorrichtung zum Polieren und Reinigen eines planaren Werkstücks, wobei folgendes vorgesehen ist:

   eine Poliereinheit mit einem ersten abreibenden Glied, welches um seine eigene Achse drehbar ist, und zwar entlang einer Polieroberfläche davon, und mit Andruck- bzw. Preßmitteln zum Pressen einer Oberfläche des planaren Werkstücks gegen die erwähnte Polieroberfläche an einer exzentrischen Position darauf, und zwar unter einem vorbestimmten Druck;
   eine Reinigungseinheit mit einem zweiten abreibenden Glied aus einem nichtgewebten Tuch, einem Tuch, das sich von einem nichtgewebten Tuch unterscheidet, oder einem Wischtuch aus ultrafeinen Fasern, wobei das zweite abreibende Glied gegen die Oberfläche des planaren Werkstücks zum Schrubben der erwähnten Oberfläche gehalten werden kann, und wobei das zweite abreibende Glied in der Lage ist, eine kreisförmige Translationsbewegung entlang eines vorbestimmten Pfades auszuführen, wobei die Reinigungseinheit ferner Preßmittel aufweist, um die erwähnte Oberfläche gegen das zweite abreibende Glied unter einem vorbestimmten Druck zu drücken.

6. Vorrichtung zum Polieren und Reinigen eines planaren Werksstücks, wobei folgendes vorgesehen ist:

   eine Poliereinheit mit einem ersten abreibenden Glied, drehbar um seine eigene Achse entlang einer Polieroberfläche davon, und Preßmittel zum Pressen der Oberfläche des planaren Werkstücks gegen die Polieroberfläche an einer exzentrischen Position darauf, und zwar unter vorbestimmtem Druck; und
   eine Reinigungseinheit mit einem zweiten abreibenden Glied aus einem nichtgewebten Tuch, einem sich von einem nichtgewebten Tuch unterscheidenden Tuch, oder einem Wischtuch aus ultrafeinen Fasern, welches gegen die Oberfläche des planaren Werkstücks gehalten werden kann, um die Oberfläche zu schrubben, wobei das zweite abreibende Glied um seine eigene Achse drehbar ist, und wobei die Reinigungseinheit ferner Preßmittel aufweist, um die erwähnte Oberfläche gegen die Polieroberfläche des zweiten abreibenden Glieds an einer exzentrischen Position darauf unter einem vorbestimmten Druck zu pressen.

## Revendications

1. Procédé de polissage et de nettoyage d'une pièce plane, comprenant les étapes consistant à :

   polir une surface de la pièce plane en pressant ladite surface contre un premier élément abrasif qui est en rotation autour de son propre axe, à une pression prédéterminée ; et
   frotter ladite surface avec un second élément abrasif d'un tissu non tissé, d'un tissu autre qu'un tissu non tissé, ou d'un tissu d'essuyage constitué de fibres ultrafines, qui est maintenu contre ladite surface, tout en frottant ladite surface avec ledit second élément abrasif, ladite surface étant pressée contre ledit second élément abrasif à une pression prédéterminée tandis que ledit second élément abrasif effectue un mouvement de translation circulatoire le long d'un trajet prédéterminé.

2. Procédé de polissage et de nettoyage d'une pièce plane comprenant les étapes consistant à :

   polir une surface de la pièce plane en pressant ladite surface contre un premier élément abrasif qui est en rotation autour de son propre axe, à une pression prédéterminée ; et
   frotter ladite surface avec un second élément abrasif d'un tissu non tissé, d'un tissu autre qu'un tissu non tissé, ou d'un tissu d'essuyage constitué de fibres ultrafines, qui est maintenu contre ladite surface, tout en frottant ladite surface avec ledit second élément abrasif, ladite surface étant pressée contre ledit second élément abrasif à une pression prédéterminée tandis que ledit second élément abrasif est en rotation autour de son propre axe.

3. Procédé selon la revendication 1, dans lequel au moins un parmi ladite pièce plane et ledit second élément abrasif est en rotation autour de son propre axe avec une période supérieure à la période dudit mouvement de translation circulatoire tandis que ladite surface est frottée avec ledit second élément abrasif.

4. Procédé selon la revendication 1, dans lequel une solution de nettoyage comprenant au moins un parmi l'eau pure, des produits chimiques, et une pâte est appliquée à ladite surface tandis que ladite surface est frottée avec ledit second élément abrasif.

5. Appareil pour polir et nettoyer une pièce plane, comprenant :

une unité de polissage comportant un premier élément abrasif rotatif autour de son propre axe le long d'une surface de polissage de celle-ci et des moyens de pressage pour presser une surface de la pièce plane contre ladite surface de polissage en une position excentrée sur celle-ci à une pression prédéterminée ; et une unité de nettoyage comportant un second élément abrasif d'un tissu non tissé, d'un tissu autre qu'un tissu non tissé, ou d'un tissu d'essuyage constitué de fibres ultrafines, qui peuvent être maintenues contre ladite surface de la pièce plane, pour frotter ladite surface, ledit second élément abrasif étant apte à effectuer un mouvement de translation circulatoire le long d'un trajet prédéterminé, ladite unité de nettoyage incluant en outre des moyens de pressage pour presser ladite surface contre ledit second élément abrasif à une pression prédéterminée.

6. Appareil pour polir et nettoyer une pièce plane, comprenant :

une unité de polissage comportant un premier élément abrasif rotatif autour de son propre axe le long d'une surface de polissage de celle-ci et des moyens de pressage pour presser une surface de la pièce plane contre ladite surface de polissage en une position excentrée sur celle-ci à une pression prédéterminée ; et une unité de nettoyage comportant un second élément abrasif d'un tissu non tissé, d'un tissu autre qu'un tissu non tissé, ou d'un tissu d'essuyage constitué de fibres ultrafines, qui peut être maintenu contre ladite surface de la pièce plane, pour frotter ladite surface, ledit second élément abrasif étant rotatif autour de son propre axe, ladite unité de nettoyage incluant en outre des moyens de pressage pour presser ladite surface contre la surface de polissage dudit second élément abrasif en une position excentrée sur celle-ci à une pression prédéterminée.

F I G. 1
PRIOR ART

# F I G. 2
## PRIOR ART

11

F I G. 3

F I G. 4

F I G. 5

F I G. 6